Europäisches Patentamt

European Patent Office

Office européen des brevets

(11) Publication number: **0 189 908 B1**

## EUROPEAN PATENT SPECIFICATION

(45) Date of publication of patent specification: **28.10.92**   (51) Int. Cl.5: **G11C 11/409**

(21) Application number: **86101143.5**

(22) Date of filing: **29.01.86**

(54) **Dynamic memory with improved arrangement for precharging bit lines.**

(30) Priority: **30.01.85 JP 15877/85**

(43) Date of publication of application:
**06.08.86 Bulletin 86/32**

(45) Publication of the grant of the patent:
**28.10.92 Bulletin 92/44**

(84) Designated Contracting States:
**DE FR GB**

(56) References cited:
**US-A- 4 397 003**

**PATENT ABSTRACTS OF JAPAN, vol. 7, no.
206 (P-222)[1351], 10th September 1983, page
149 P 222; & JP-A-58 102 389 (NIPPON DEN-
SHIN DENWA KOSHA) 17-06-1983**

**PATENT ABSTRACTS OF JAPAN, vol. 2, no.
32 (E-77)[12265], 2nd February 1978, page
12265 E 77; & JP-A-52 152 129 (NIPPON DEN-
SHIN DENWA KOSHA) 17-12-1977**

(73) Proprietor: **NEC CORPORATION
7-1, Shiba 5-chome Minato-ku
Tokyo 108-01(JP)**

(72) Inventor: **Murotani, Tatsunori
c/o NEC Corporation 33-1, Shiba 5-chome
Minato-ku Tokyo(JP)**

(74) Representative: **Glawe, Delfs, Moll & Partner
Patentanwälte
Postfach 26 01 62 Liebherrstrasse 20
W-8000 München 26(DE)**

EP 0 189 908 B1

**Description**

BACKGROUND OF THE INVENTION:

The present invention relates to a dynamic memory composed of semiconductor elements, and more particularly to a circuit for precharging bit lines of the dynamic memory.

Dynamic memories employing one-transistor type memory cells have been dominantly utilized as large capacity memories. The one-transistor type memory cell is comprised of a storage capacitor and a transfer gate MOS transistor connected between the storage capacitor and a bit line and having a gate coupled to a word line. In order to achieve high sensitivity detection of a stored signal in a selected memory cell, a differential type sense amplifier is provided for each pair of bit lines. Prior to access operation, each pair of bit lines are precharged to a power voltage. Then, one of a pair of bit lines is subjected to change in potential due to a content of a selected memory cell while a charge stored in a dummy cell storing intermediate amount of charge of the respective charged corresponding to logics "1" and "0" states of a memory cell is applied to the other bit line of the bit line pair. Then a sense amplifier is enabled to amplify the difference in potential between the bit lines of the bit line pair such that one of the bit line pair such that one of the bit lines is discharged from the power voltage to a ground potential while the other bit line maintains the power voltage.

Recently, an improved technique for precharging bit lines was proposed. According to this technique, after potentials on a pair of bit lines are discriminated into the power voltage $V_{cc}$ and a ground potential, the pair of bit lines are short-circuited. Thus, the potential of the pair of bit lines are set approximately to half the power voltage i.e. $1/2$ $V_{cc}$ due to charge division by the pair of bit lines. This technique is advantageous in that a power consumption of a memory can be significantly reduced, and it is possible to eliminate a dummy cell which has been necessitated to operate a sense amplifier. However, in a bit line pair, a potential of the higher potential side bit line is of half the power voltage or less when amplification by a differential sense amplifier is completed. Therefore, in order to re-write the power voltage to the selected memory cell storing "1" for refreshing "1" of the selected memory cell and to raise the higher potential side bit line to the power voltage for subsequent short-circuiting explained above, the higher potential side bit line is raised in potential to the power voltage $V_{cc}$ by an active pull-up circuit employing a boosting capacitor through which the power voltage is applied to the higher potential side bit line. However, when a pair of bit lines are short-circuited, the boosting capacitor is also connected to the pair of bit lines, especially to the higher potential side bit line. Also in this instance, certain regions of transistors of the sense amplifier is connected to the short-circuited bit lines to impose a capacitance thereon. Accordingly, the resultant potential remaining on the pair of bit lines does not reach the exact half the power voltage but takes a value less than it. As a result, the voltage set at the pair of bit lines shifts from a center value between the power voltage which is stored in a "1" storing memory cell and the ground potential which is stored in a "0" storing memory cell. Thus, a differential voltage between the precharged potential of a bit line and a potential stored in a selected memory cell is different according to whether the selected memory cell stores "1" or "0". This means that operational margin for a sense amplifier varies according to the content stored in a selected memory cell, resulting in unstable operation.

SUMMARY OF THE INVENTION:

It is an object of the present invention to provide a dynamic memory provided with an improved arrangement for precharging a pair of bit lines accurately to the half the power voltage.

This object is achieved by a memory as defined in claims 1, 4 and 7, respectively. The dependent claims are related to further developments of the invention.

According to the present invention, charge stored in the compensation capacitor compensates a potential drop due to a capacitance of the boost capacitor and a capacitance of the common node and raises a potential on the short-circuited bit lines to the half the power voltage effectively. The capacitance of the compensation capacitor is selected to the sum of the capacitances of the boost capacitor and the common node.

According to the present invention, the pair of bit lines are accurately precharged to half the power voltage, sense of a signal stored in a selected memory cell can be performed with a high-sensitivity and increased stability.

DETAILED DESCRIPTION OF THE DRAWINGS:

Fig. 1 is a schematic circuit diagram showing a major part of a dynamic memory according to a prior art;
Fig. 2 is a timing chart showing operation of the circuit of Fig. 1;
Fig. 3 is a schematic circuit diagram showing a major part of a dynamic memory according to a first embodiment of the invention;
Fig. 4 is a timing chart showing operation of the circuit of Fig. 3;
Fig. 5 is a schematic circuit diagram showing a dynamic memory according to a second embodiment of the present invention; and
Fig. 6 is a schematic circuit diagram showing a dynamic memory according to a third embodiment of the present invention:

DETAILED DESCRIPTION OF THE INVENTION:

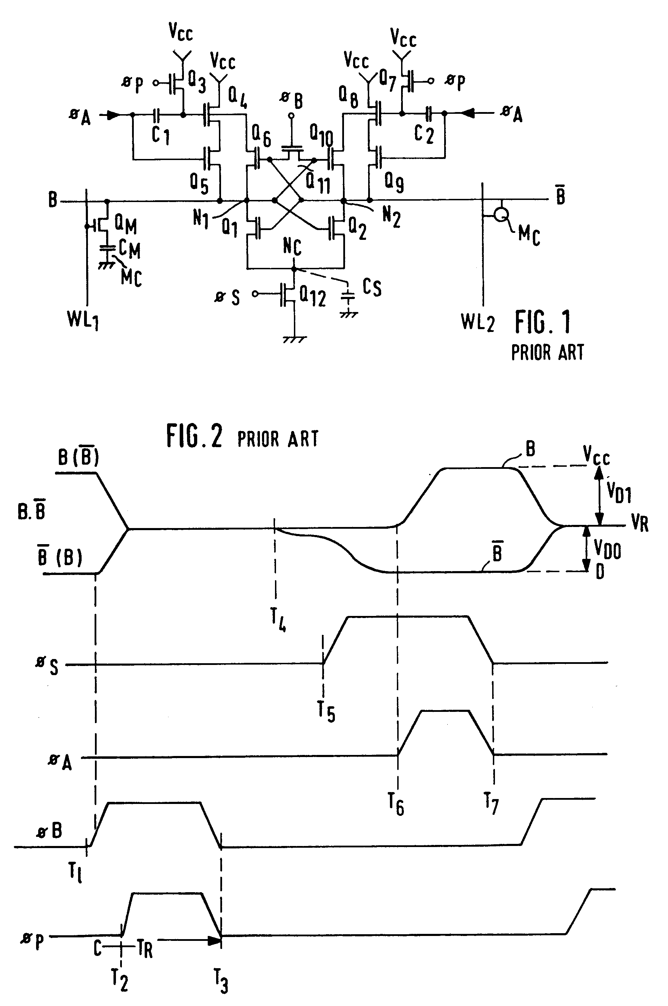

Fig. 1 shows a major part of a dynamic memory according to a prior art. MOS field effect transistors (MOSTs) $Q_1$ and $Q_2$ having gates and drains cross-coupled at nodes $N_1$ and $N_2$ and sources commonly connected to a common node $N_c$ and a discharge MOST $Q_{12}$ form a known flip-flop type sense amplifier. A pair of bit lines B and $\overline{B}$ are connected to the nodes $N_1$ and $N_2$, respectively. A plurality of word lines $WL_1$, $WL_2$ or the like intersect with the bit lines. Memory cells MC each comprised of a transfer MOST $Q_M$ and a storage capacitor $C_M$ are connected to the bit lines and word lines in a known way. MOSTs $Q_3$, $Q_4$, $Q_5$ and $Q_6$ and a boost capacitor $C_1$ form an active pull-up circuit for the bit line B while MOSTs $Q_7$, $Q_8$, $Q_9$ and $Q_{10}$ and a boost capacitor $C_2$ form another active pull-up circuit for the bit line $\overline{B}$. A MOST $Q_{11}$ connected between the nodes $N_1$ and $N_2$ short-circuits between the pair of bit lines B and $\overline{B}$ so as to precharge them with an intermediate voltage of the power voltage $V_{cc}$ and a ground potential (GND), after a potential difference between the pair of bit lines are amplified and discriminated into $V_{cc}$ and GND.

Referring to Fig. 2, operation of the circuit of Fig. 1 will be described.

A pulse $\phi_B$ changes from a low (GND) level to a high level ($V_{cc}$) so that MOST $Q_{11}$ is rendered conductive at $T_1$. Accompanied by this, the bit lines B and $\overline{B}$ which have been of $V_{cc}$ and GND respectively change to the same intermediate voltage $V_R$ as a reference for operating the sense amplifier. While in parallel with this change, a pulse $\phi_P$ is raised to $V_{cc}$ at a time $T_2$. Accordingly, output ends of the boost capacitors $C_1$ and $C_2$ are charged to $V_{cc}$. In this instance, gates and sources of MOSTs $Q_6$ and $Q_{10}$ are biased at $V_R$ and hence MOSTs $Q_6$ and $Q_{10}$ are not conducting to ensure the precharge of the output ends of the capacitors $C_1$ and $C_2$. The pulses $\phi_B$ and $\phi_P$ change to a low level at a time $T_3$, to complete a reset precharge period $T_R$. Then, at a time $T_4$ one of word lines, e.g. $WL_2$ is selected and the bit line $\overline{B}$ is lowered in potential slightly due to "0" level stored in a selected memory cell with the bit line B remaining at $V_R$. Then, a pulse $\phi_s$ is raised at a time $T_5$ to render MOST $Q_{12}$ conductive. Thus, the lower potential side bit line $\overline{B}$ is discharged to GND without materially discharging the higher potential side bit line B by the flip-flop composed of MOSTs $Q_1$ and $Q_2$.

In this instance, MOST $Q_{10}$ becomes conductive due to the discharged level of the bit line $\overline{B}$ and therefore the capacitor $C_2$ arranged for the lower potential side bit $\overline{B}$ is discharged, while charge of the capacitor $C_1$ is maintained. Subsequently, a pulse $\phi_A$ is raised at a time $T_6$ so that a gate potential of MOST $Q_4$ is raised above $V_{cc}$ through the capacitor and MOST $Q_6$ assumes a conductive state. Therefore, the power voltage $V_{cc}$ is applied to the higher potential side bit line B through MOSTs $Q_4$ and $Q_5$ thereby to achieve pulling-up of the bit line B to $V_{cc}$ in potential. While the capacitor $C_2$ has been discharged and MOST $Q_{10}$ has been conductive so that a gate potential cannot be raised by $\phi_A$. Therefore, MOST $Q_8$ remains non-conductive so that the power voltage $V_{cc}$ is not applied to the lower potential side bit line $\overline{B}$. Thus, the potential difference between the bit lines B and $\overline{B}$ is extended to $V_{cc}$. Then, the pulses $\phi_A$ and $\phi_S$ are changed to GND potential at a time $T_7$ to complete an access cycle.

In the following, a practical value of $V_R$ obtained in the circuit of Fig. 1 will be discussed.

The pair of bit lines B and $\overline{B}$ are designed to have the same capacitance "$C_B$". After completion of pulling-up, a pair of bit lines B and $\overline{B}$ prima-facially seem to become the potential $V_R$ of 1/2 $V_{cc}$ due to charge division expressed as:

$$V_R = \frac{V_{cc} \times C_B + 0 \times C_B}{2 C_B} = \frac{1}{2} V_{cc}$$

However, this assumption is not practically correct by the following reason. As is clear from Fig. 1, when a pair of bit lines B and $\overline{B}$ are short-circuited, the node NC and the boost capacitor $C_2$ are also

connected to the short-circuited bit lines B and $\overline{B}$. Therefore, electric charge of the bit line B of $V_{cc}$ is divided by not only the bit lines B and $\overline{B}$ but also the capacitor $C_2$ and a capacitance of the node $N_c$. Therefore, representing the capacitance of the capacitor $C_1$ ($C_2$) as "$C_A$" and the capacitance of the node $N_c$ as "$C_S$", a practical value of the voltage $V_R$ is determined by the following equation (1):

$$V_R = \frac{V_{cc} \times C_B + 0 \times C_B}{2\,C_B + C_A + C_S}\,V_{cc} < \frac{1}{2}\,V_{cc} \qquad \cdots\cdots (1)$$

As a result, it should be understood that the practical value of $V_R$ is lower than the half the power voltage.

In a practical dynamic memory, values of $C_B$, $C_A$ and $C_S$ are 0.5 pF, 0.05 pF and 0.1 pF, respectively. Therefore, the value of $V_R$ becomes about 0.43 $V_{cc}$ which is lower than 1/2 $V_{cc}$. As is well known, it is desirable to select the value of $V_R$ at a center value (1/2 $V_{cc}$) of two potentials $V_{cc}$ and GND corresponding to "1" and "0" information stored in a memory cell. In the case where the value of $V_R$ is lower than 1/2 $V_{cc}$, the potential difference $V_{D1}$ between $V_R$ and a potential ($V_{cc}$) of a "1" storing memory cell becomes large while the potential difference $V_{D0}$ between $V_R$ and a potential (GND) of a "0" storing memory cell becomes small, as shown in Fig. 2. This means that operation margin of a sense amplifier is changed according to the content of a selected memory cell, resulting low operation stability.

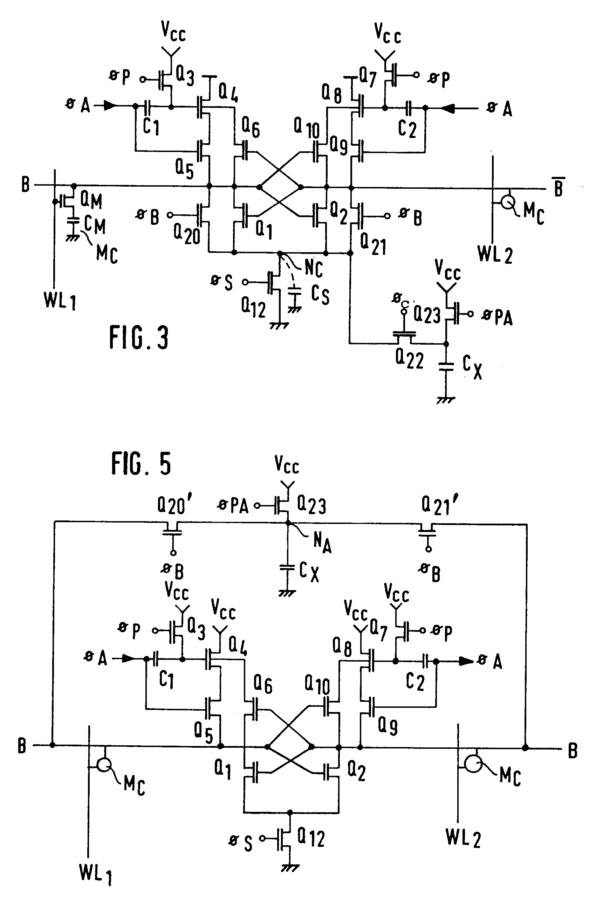

Referring to Fig. 3, a dynamic memory according to a first embodiment of the invention will be explained.

In Fig. 3, portions corresponding to those in Fig. 1 are designated by the same references.

According to the embodiment, in place of MOST $Q_{11}$ in Fig. 1, MOST $Q_{20}$ connected between the bit line B and the common node $N_C$ and MOST $Q_{21}$ connected between the bit line $\overline{B}$ and the node $N_C$ are provided for short-circuiting the bit lines B, $\overline{B}$ and the node $N_C$. A compensation capacitor $C_X$ is provided according to the invention. A MOST $Q_{23}$ is provided for charging an output end of the capacitor $C_X$ to $V_{cc}$ in response to a pulse $\phi_{PA}$ and a MOST $Q_{22}$ operatively connects the output end of the capacitor $C_X$ to the node $N_C$ in response to the pulse $\phi_B$. According to this arrangement, when the bit lines B, $\overline{B}$, the node $N_C$, the capacitor $C_1$ or $C_2$ and the capacitor $C_X$ are short-circuited in response to the pulse $\phi_0$ for generating $V_R$ on the bit lines B and $\overline{B}$, after the capacitor $C_X$ is charged to $V_{cc}$. Therefore a resultant value of $V_R$ on the bit lines B and $\overline{B}$ is denoted by the following equation (2):

$$V_R = \frac{C_B + C_X}{2\,C_B + C_A + C_S + C_X}\,V_{cc} \qquad \cdots\cdots (2)$$

Then, if the following relation (3) is fulfilled,

$$C_X \fallingdotseq C_A + C_S \qquad (3)$$

a value of $V_R$ becomes approximately 1/2 $V_{cc}$.

Therefore, the capacitance of the capacitor $C_X$ is selected to have a value corresponding to the sum of the capacitance of the capacitor $C_1$ ($C_2$) and the capacitance of the node $N_C$.

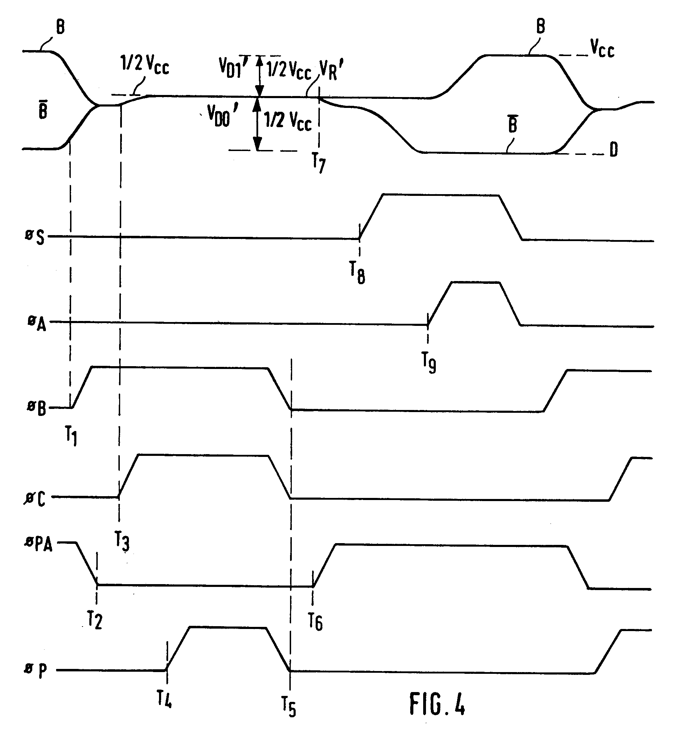

Referring to Fig. 4, operation of the circuit of Fig. 3 will be described.

Prior to a time $T_2$, the capacitor $C_X$ is charged to $V_{cc}$ through MOST $Q_{23}$ in response to $\phi_{PA}$, while the pulse $\phi_B$ is raised to $V_{cc}$ at a time $T_1$ so that the pair of bit lines B and $\overline{B}$, the node $N_C$ and the capacitor $C_2$ are short-circuited by MOSTs $Q_{20}$ and $Q_{21}$ so that the potential on the bit lines B and $\overline{B}$ becomes a potential which is lower than 1/2 $V_{cc}$ similarly to the case of Fig. 1. Then, MOST $Q_{22}$ becomes conductive in response to the rise of $\phi_C$ to connect the output end of the capacitor $C_X$ to the short-circuited bit lines B and $\overline{B}$. According to this, as explained by the equations (2) and (3), the potential on the bit lines B and $\overline{B}$ shifts to 1/2 $V_{cc}$ ($V_R'$), achieving a precharge of the bit lines B and $\overline{B}$. At a time $t_4$, the capacitors $C_1$ and $C_2$ are precharged to $V_{cc}$ in response to $\phi_P$, similarly to the circuit of Fig. 1. Then, a content of a selected memory cell is applied to the bit line $\overline{B}$ at a time $T_7$ so that the bit line $\overline{B}$ is reduced slightly in potential due to "0" content of the selected memory cell. Then, the sense amplifier and the active pull-up circuits are sequentially enabled by $\phi_S$ and $\phi_A$ at a time $T_8$ and a time $T_9$, respectively in the same manner as in Fig. 1 to achieve an access operation. According to this invention, prior to an access operation from $T_7$, the bit lines B and $\overline{B}$ are accurately precharged to 1/2 $V_{cc}$, and therefore the voltage difference $V_{D1}'$ between the precharge voltage $V_R'$ and the potential of a "1" storing memory cell and the voltage difference $V_{D0}'$ between $V_R'$ and the potential of a "0" storing memory cell are made equal from eath other. Thus, a high-sensitive and stable amplifying operation is obtained.

In a 256 k-bit dynamic memory, a value of $C_S$ and the capacitance $C_A$ of the capacitors $C_1$, $C_2$ are 0.1 pF and 0.05 pF, respectively, then the value of capacitance of the capacitor $C_X$ is selected to 0.15 ($C_X = C_A + C_S = 0.05 + 0.1$) pF, in this case.

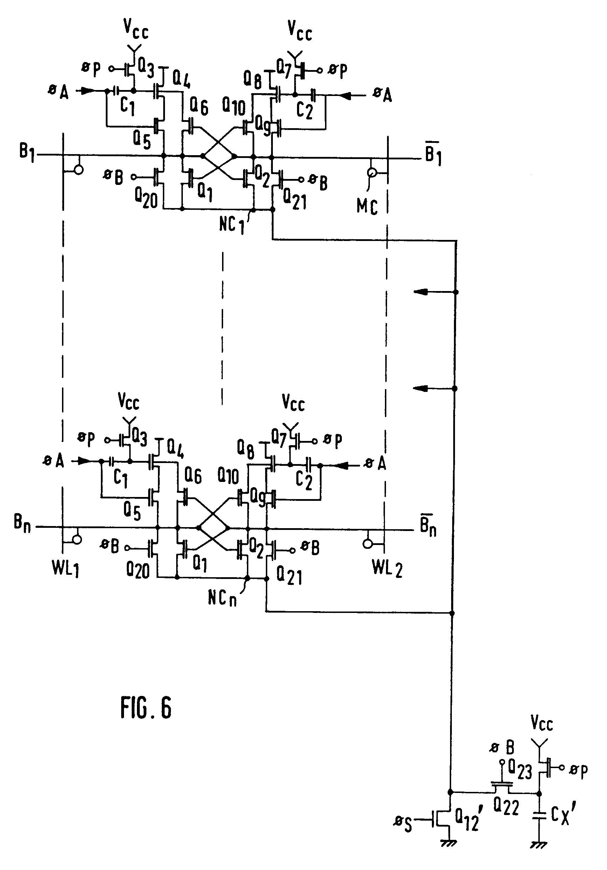

Fig. 5 shows a second embodiment of the present invention.

This embodiment is obtained by directly connecting the output end of the capacitor $C_X$ to the pair of bit lines B and $\overline{B}$ by MOST $Q_{20'}$ and $Q_{21}$ in place of MOSTs $Q_{20}$ to $Q_{22}$ in Fig. 3. According to this embodiment, MOST $Q_{22}$ and the pulse $\phi_C$ are obviated. As far as the capacitance of the capacitor $C_X$ is determined according to the equation (3), this embodiment also provides the same effect. Timing relations of the respective pulses in this circuit are substantially the same as those in Fig. 3.

Referring to Fig. 6, a third embodiment of the present invention will be described.

This embodiment is featured in that the common nodes $NC_1$ to $NC_n$ of a plurality sense amplifiers for a plurality pairs of bit lines $B_1$, $\overline{B}$, to $B_n$, $\overline{B_n}$ are connected in common and MOST $Q_{12}'$ for enabling the sense amplifiers in response to $\phi_S$ and MOSTs $Q_2$ and $Q_{23}$ and the capacitor $C_X'$ are connected to the commonly connected nodes $NC_1$ to $NC_n$, as illustrated. In this case, the capacitance of the capacitor $C_X'$ is selected "n" times the sum of the capacitance $C_A$ of each capacitor $C_1$, $C_2$ and the capacitance $C_S$ of each node ($NC_1$ to $NC_n$), "n" being the number of the sense amplifiers.

Therefore, for a 256 k-bit dynamic memory, the number "n" of the sense amplifiers is 1024, then the value of $C_X'$ becomes as follows:

$$C_X' = 1024 \times (C_A + C_S) = 1024 \times (0.05 + 0.1) \fallingdotseq 154 \text{ pF}$$

As has been described above, according to the present invention, a pair of bit lines B and $\overline{B}$ are accurately precharged to 1/2 $V_{cc}$. Therefore a dynamic memory having a high-sensitivity can be obtained.

**Claims**

1. A dynamic memory comprising a pair of bit lines (B,$\overline{B}$), amplifying means ($Q_1$,$Q_2$,$Q_{12}$) having a pair of input/output nodes and at least one internal node capacitance (Cs), means for connecting said pair of bit lines to said pair of input/output nodes, first means for operatively enabling said amplifying means thereby to discriminate potentials on said pair of bit lines into first and second voltages, second means ($Q_{20}$,$Q_{21}$) for operatively short-circuiting said pair of bit lines after said amplifying means is disabled by said first means, said internal node capacitance being connected to said pair of bit lines when said pair of bit lines are short-circuited, characterized by capacitor means (Cx), third means (Q23,Vcc,$\phi$PA) for charging said capacitor means (Cx) before said pair of bit lines are short-circuited, and fourth means ($Q_{22}$,$\phi$c) for transmitting charge accumulated in said capacitor means (Cx) to said pair of bit lines (B,$\overline{B}$) when said pair of bit lines are short-circuited, said capacitor means (Cx), third means and fourth means being adapted to compensate for a deviation of the potential to which the pair of bit lines (B,$\overline{B}$) are precharged by short-circuiting the bit lines, said deviation being due to said internal node capacitance (Cs).

2. The dynamic memory according to claim 1, in which said capacitor means (Cx) has a capacitance substantially equal to said internal node capacitance (Cs).

3. The dynamic memory according to claim 1, said amplifying means ($Q_1$,$Q_2$,$Q_{12}$) includes a flip-flop circuit and a pair of pull-up circuits ($Q_3$,$Q_4$,$Q_5$,$Q_6$,$C_1$;$Q_7$,$Q_8$,$Q_9$,$Q_{10}$,$C_2$) provided for said pair of bit lines.

4. A dynamic memory of the type having a pair of bit lines (B,$\overline{B}$), first and second sense nodes, a common node (Nc), a first transistor ($Q_1$) having a source-drain path connected between said first sense node and said common node (Nc) and a gate connected to said second node, a second transistor ($Q_2$) having a source-drain path connected between said second sense node and said common node (Nc) and a gate connected to said first node, means for connecting one of said pair of bit lines to said first sense node, means for connecting the other of said pair of bit lines to said second sense node, means ($Q_{20}$,$Q_{21}$) for operatively short-circuiting said pair of bit lines (B,$\overline{B}$), wherein said common node (Nc) is connected to said pair of bit lines (B,$\overline{B}$) when said pair of bit lines is short-circuited, a pair of pull-up circuits ($Q_3$,$Q_4$,$Q_5$,$Q_6$,$C_1$;$Q_7$,$Q_8$, $Q_9$,$Q_{10}$,$C_2$) coupled to said pair of bit lines,

5

each of said pull-up circuits including a first capacitor ($C_1$,$C_2$) one of said pull-up circuits coupled to one of said pair of bit lines having a higher potential raising said one bit line of higher potential to a power potential (Vcc), the first capacitor of the other of said pair of pull-up circuits coupled to the other bit line of a lower potential being electrically connected to said pair of bit lines when said pair of bit lines (B,$\overline{B}$) are short-circuited by said short-circuiting means ($Q_{20}$,$Q_{21}$);

characterized by comprising a second capacitor (Cx), first means for operatively charging one end of said second capacitor to said power voltage (Vcc) before said pair of bit lines are short-circuited, and second means for connecting said one end of said second capacitor to said pair of bit lines when said pair of bit lines are short-circuited, said capacitor means (Cx), first means and second means being adapted to compensate for a deviation of the potential to which the pair of bit lines (B,$\overline{B}$) are precharged by short-circuiting the bit lines, said deviation being due to said capacitances of said common node and the first capacitor.

5. The invention as claimed in claim 4, in which a capacitance of said second capacitor (Cx) is selected to the sum of capacitances of said common node (Nc) and said first capacitor.

6. The invention as claimed in claim 4, in which said short-circuiting means includes a third transistor ($Q_{20}$) having a source-drain path coupled between one of said bit lines and said common node (Nc) and a fourth transistor ($Q_{21}$) coupled between the other of said pair of bit lines and said common node (Nc).

7. A dynamic memory comprising a plurality of pairs of bit lines (B,$\overline{B}$), a plurality of amplifying means ($Q_1$,$Q_2$,$Q_{12}$') provided for said plurality of pairs of bit lines, each of said amplifying means connected to each pair of bit lines (B,$\overline{B}$) to operatively amplify potentials on said pair of bit lines into first and second voltages and including an internal capacitance, means for enabling said plurality of sense amplifiers simultaneously a plurality of first means provided for said plurality of pairs of bit lines, each of said first means ($Q_{20}$,$Q_{21}$;$Q_{20}$',$Q_{21}$') operatively short-circuiting each pair of bit lines (B,$\overline{B}$) after potentials on said each pair of bit lines are amplified by said amplifying means ($Q_1$,$Q_2$,$Q_{12}$'), said internal capacitance of each of said amplifying means being connected to the associated pair of bit lines when said associated pair of bit lines are short-circuited, characterized by capacitor means (Cx'), second means ($Q_{23}$) for charging said capacitor means (Cx') before said plurality of sense amplifiers are enabled, and third means for operatively connecting said capacitor means (Cx') to said internal nodes of said amplifying means when each pair of bit lines are short-circuited, said capacitor means (Cx'), second means and third means being adapted to compensate for a deviation of the potential to which the pair of bit lines (B,$\overline{B}$) are precharged by short-circuiting the bit lines, said deviation being due to said internal capacitances of said plurality of amplifying means.

8. The dynamic memory according to claim 7, in which said capacitance means (Cx) has a capacitance substantially equal to a total capacitance of said internal capacitances.

## Patentansprüche

1. Dynamischer Speicher mit einem Paar Bitleitungen (B, $\overline{B}$), einer Verstärkereinrichtung ($Q_1$, $Q_2$, $Q_{12}$) mit einem Paar Eingangs/Ausgangsknoten und zumindest einer inneren Knotenkapazität (Cs), einer Einrichtung zum Verbinden des Paares Bitleitungen mit dem Paar Eingangs/Ausgangsknoten, einer ersten Einrichtung zum operativen Freigeben der Verstärkereinrichtung und damit zum Unterscheiden von Potentialien auf dem Paar Bitleitungen in eine erste und eine zweite Spannung, einer zweiten Einrichtung ($Q_{20}$, $Q_{21}$) zum operativen Kurzschließen des Paares Bitleitungen nachdem die Verstärkereinrichtung durch die erste Einrichtung gesperrt wurde, wobei die innere Knotenkapazität mit dem Paar Bitleitungen verbunden ist, wenn das Paar Bitleitungen kurzgeschlossen ist, **gekennzeichnet** durch eine Kondensatoreinrichtung (Cx), eine dritte Einrichtung ($Q_{23}$, Vcc, $\phi$PA) zum Laden der Kondensatoreinrichtung (Cx) bevor das Paar Bitleitungen kurzgeschlossen wird, und eine vierte Einrichtung ($Q_{22}$, $\phi$c) zum Übertragen der in der Kondensatoreinrichtung (Cx) gesammelten Ladung an das Paar Bitleitungen (B, $\overline{B}$), wenn das Paar Bitleitungen kurzgeschlossen ist, wobei die Kondensatoreinrichtung (Cx), die dritte Einrichtung und die vierte Einrichtung angepaßt sind zum Kompensieren einer Abweichung des Potentials, auf das das Paar Bitleitungen (B, $\overline{B}$) aufgeladen wird durch Kurzschließen der Bitleitungen und wobei die Abweichung durch die innere Knotenkapazität (Cs) begründet ist.

6

**2.** Dynamischer Speicher nach Anspruch 1, bei der die Kondensatoreinrichtung (Cx) eine der inneren Knotenkapazität (Cs) im wesentlichen gleiche Kapazität aufweist.

**3.** Dynamischer Speicher nach Anspruch 1, wobei die Verstärkereinrichtung ($Q_1$, $Q_2$, $Q_{12}$) eine Flip-Flop-Schaltung und ein Paar für das Paar Leitungen vorgesehene Hochziehschaltungen ($Q_3$, $Q_4$, $Q_5$, $Q_6$, $C_1$; $Q_7$, $Q_8$, $Q_9$, $Q_{10}$, $C_2$) aufweist.

**4.** Dynamischer Speicher mit einem Paar Bitleitungen (B, $\overline{B}$), ersten und zweiten Leseknoten, einem gemeinsamen Knoten (Nc), einem ersten Transistor ($Q_1$) dessen Source-Drain-Pfad zwischen dem ersten Leseknoten und dem gemeinsamen Knoten (Nc) geschaltet ist und dessen Gate mit dem zweiten Knoten verbunden ist, einem zweiten Transistor ($Q_2$), dessen Source-Drain-Pfad zwischen dem zweiten Leseknoten und dem gemeinsamen Knoten (Nc) geschaltet ist und dessen Gate mit dem ersten Knoten verbunden ist, einer Einrichtung zum Verbinden einer Leitung des Paares Bitleitungen mit dem ersten Leseknoten, einer Einrichtung zum Verbinden der anderen Leitung des Paares Bitleitungen mit dem zweiten Knoten, einer Einrichtung ($Q_{20}$, $Q_{21}$) zum operativen Kurzschließen des Paares Bitleitungen (B, $\overline{B}$), wobei der gemeinsame Knoten (Nc) mit dem Paar Bitleitungen (B, $\overline{B}$) verbunden ist, wenn das Paar Bitleitungen kurzgeschlossen ist, einem Paar Hochziehschaltungen ($Q_3$, $Q_4$, $Q_5$, $Q_6$, $C_1$; $Q_7$, $Q_8$, $Q_9$, $Q_{10}$, $C_2$), das mit dem Paar Bitleitungen gekoppelt ist, wobei jede der Hochziehschaltungen einen ersten Kondensator ($C_1$, $C_2$) aufweist, eine der Hochziehschaltungen, die mit einer Leitung des Paares Bitleitungen gekoppelt ist, ein höheres Potential aufweist, das die eine Bitleitung höheren Potentials auf ein Speisepotential (Vcc) anhebt, wobei der erste Kondensator der anderen Schaltung des Paares Hochziehschaltungen, die mit der anderen Bitleitung mit niedrigerem Potential gekoppelt ist, elektrisch mit dem Paar Bitleitungen verbunden ist, wenn das Paar Bitleitungen (B, $\overline{B}$) durch die Kurzschlußeinrichtung ($Q_{20}$, $Q_{21}$) kurzgeschlossen ist, **gekennzeichnet** durch einen zweiten Kondensator (Cx), eine erste Einrichtung zum operativen Aufladen eines Endes des zweiten Kondensators auf die Speisespannung (Vcc) bevor das Paar Bitleitungen kurzgeschlossen ist, und eine zweite Einrichtung zum Verbinden des einen Endes des zweiten Kondensators mit dem Paar Bitleitungen, wenn das Paar Bitleitungen kurzgeschlossen ist, wobei die Kondensatoreinrichtung (Cx), die erste Einrichtung und die zweite Einrichtung angepaßt sind zum Kompensieren einer Abweichung des Potentials, auf das das Paar Bitleitungen (B, B) vorgeladen wird durch Kurzschließen der Bitleitungen, wobei die Abweichung durch die Kapazitäten des gemeinsamen Knotens und des ersten Kondensators begründet ist.

**5.** Speicher nach Anspruch 4, wobei die Kapazität des Zweiten Kondensators (Cx) als Summe der Kapazitäten des gemeinsamen Knotens (Nc) und des ersten Kondensators ausgewählt ist.

**6.** Speicher nach Anspruch 4, wobei die Kurzschlußeinrichtung einen dritten Transistor ($Q_{20}$) aufweist, dessen Source-Drain-Pfad zwischen eine der Bitleitungen und dem gemeinsamen Knoten (Nc) geschaltet ist, und einen vierten Transistor ($Q_{21}$), der zwischen die andere des Paares Bitleitungen und dem gemeinsamen Knoten (Nc) gekoppelt ist.

**7.** Dynamischer Speicher mit einer Anzahl von Paaren Bitleitungen (B, $\overline{B}$), einer Anzahl Verstärkereinrichtungen ($Q_1$, $Q_2$, $Q_{12}'$), die für die Anzahl der Paare Bitleitungen vorgesehen sind, wobei jeweils die Verstärkereinrichtungen mit dem jeweiligen Paar Bitleitungen (B, $\overline{B}$) verbunden sind, um operativ Potentiale auf dem Paar Bitleitungen in erste und zweite Spannungen zu verstärken und eine innere Kapazität enthalten, eine Einrichtung zum gleichzeitigen Freigeben der Anzahl von Leseverstärkern, eine Anzahl von ersten Einrichtungen, die für die Anzahl von Paaren von Bitleitungen vorgesehen ist, wobei jede der ersten Einrichtungen ($Q_{20}$, $Q_{21}$; $Q_{20}'$, $Q_{21}'$) operativ jedes Paar Bitleitungen kurzschließt nachdem die Potentiale auf jedem Paar Bitleitungen durch Verstärkereinrichtungen ($Q_1$, $Q_2$, $Q_{12}'$) verstärkt wurden, wobei die innere Kapazität jeder der Verstärkereinrichtungen mit dem zugeordneten Paar Bitleitungen verbunden ist, wenn das zugeordnete Paar Bitleitungen kurzgeschlossen ist, **gekennzeichnet** durch eine Kondensatoreinrichtung (Cx'), eine zweite Einrichtung $Q_{23}$) zum Laden der Kondensatoreinrichtung (Cx') bevor die Anzahl der Leseverstärker freigegeben wird, und eine dritte Einrichtung zum operativen Verbinden der Kondensatoreinrichtung (Cx') mit dem inneren Knoten der Verstärkereinrichtung, wenn jedes Paar Bitleitungen kurzgeschlossen ist, wobei die Kondensatoreinrichtung (Cx'), die zweite Einrichtung und die dritte Einrichtung ausgebildet sind zum Kompensieren einer Abweichung des Potentials, auf das das Paar Bitleitungen (B, B) aufgeladen wird durch Kurzschließen der Bitleitungen, wobei die Abweichung durch die inneren Kapazitäten der Anzahl der Verstärkerein-

7

richtungen begründet ist.

8. Dynamischer Speicher nach Anspruch 7, wobei die Kapazitätseinrichtung (Cx) eine der Gesamtkapazität der inneren Kapazitäten entsprechende Kapazität aufweist.

**Revendications**

1. Mémoire dynamique comprenant une paire de lignes de bits (B, $\overline{B}$), un moyen d'amplification ($Q_1$, $Q_2$, $Q_{12}$) ayant une paire de noeuds d'entrée/sortie et au moins une capacitance de noeud interne (Cs), un moyen pour connecter la paire de lignes de bits à la paire des noeuds d'entrée/sortie, un premier moyen pour activer de manière fonctionnelle le moyen d'amplification pour discriminer de ce fait les potentiels sur la paire des lignes de bits en première et seconde tensions, un second moyen ($Q_{20}$, $Q_{21}$) pour court-circuiter de manière fonctionnelle la paire des lignes de bits après que le moyen d'amplification soit désactivé par le premier moyen, la capacitance de noeud interne étant connectée à la paire des lignes de bits lorsque la paire des lignes de bits est court-circuitée, caractérisé par un moyen de condensateur (Cx), un troisième moyen ($Q_{23}$, Vcc, $\phi$PA) pour charger le moyen de condensateur (Cx) avant que la paire des lignes de bits soit court-circuitée et un quatrième moyen ($Q_{22}$, $\phi$c) pour transmettre la charge accumulée dans le moyen de condensateur (Cx) à la paire des lignes de bits (B, $\overline{B}$) lorsque la paire des lignes de bits est court-circuitée, le moyen de condensateur (Cx), le troisième moyen et le quatrième moyen étant prévus pour compenser un écart de potentiel auquel la paire de lignes de bits (B, $\overline{B}$) est préchargée en court-circuitant les lignes de bits, ledit écart étant dû à la capacitance du noeud interne (Cs).

2. Mémoire dynamique selon la revendication 1, dans laquelle le moyen de condensateur (Cx) présente une capacitance pratiquement égale à la capacitance du noeud interne (Cs).

3. Mémoire dynamique selon la revendication 1, dans laquelle le moyen d'amplification ($Q_1$, $Q_2$, $Q_{12}$) comporte un circuit de bascule et une paire de circuits de charge ($Q_3$, $Q_4$, $Q_5$, $Q_6$, $C_1$ ; $Q_7$, $Q_8$, $Q_9$, $Q_{10}$, $C_2$) prévus pour la paire des lignes de bits.

4. Mémoire dynamique du type comportant une paire de lignes de bits (B, $\overline{B}$), des premier et second noeuds de détection, un noeud commun (Nc), un premier transistor ($Q_1$) ayant un trajet source-drain connecté entre le premier noeud de détection et le noeud commun (Nc) et une grille connectée au second noeud, un second transistor ($Q_2$) ayant un trajet source-drain connecté entre le second noeud de détection et le noeud commun (Nc) et une grille connectée au premier noeud, un moyen pour connecter une ligne de bits parmi la paire des lignes de bits au premier noeud de détection, un moyen pour connecter l'autre ligne parmi la paire des lignes de bits au second noeud de détection, un moyen ($Q_{20}$, $Q_{21}$) pour court-circuiter de manière fonctionnelle la paire des lignes de bits (B, $\overline{B}$), dans laquelle le noeud commun (Nc) est connecté à la paire des lignes de bits (B, $\overline{B}$) lorsque la paire des lignes de bits est court-circuitée, une paire de circuits de charge ($Q_3$, $Q_4$, $Q_5$, $Q_6$, $C_1$ ; $Q_7$, $Q_8$, $Q_9$, $Q_{10}$, $C_2$) couplée à la paire des lignes de bits, chaque circuit des circuits de charge comportant un premier condensateur ($C_1$, $C_2$), un des circuits de charge couplé à une ligne de bits parmi la paire des lignes de bits ayant un potentiel plus élevé montant la ligne de bits du potentiel plus élevé à un potentiel d'alimentation (Vcc), le premier condensateur de l'autre circuit de la paire des circuits de charge couplé à l'autre ligne de bits d'un potentiel inférieur étant électriquement connecté à la paire des lignes de bits lorsque la paire des lignes de bits (B, $\overline{B}$) est court-circuitée par le moyen de mise en court-circuit ($Q_{20}$, $Q_{21}$) ; caractérisée en ce qu'elle comprend un second condensateur (Cx), un premier moyen pour charger fonctionnellement un côté du second condensateur à la tension d'alimentation (Vcc) avant que la paire de lignes de bits soit court-circuitée et un second moyen pour connecter un côté du second condensateur à la paire des lignes de bits lorsque la paire des lignes de bits est court-circuitée, le moyen de condensateur (Cx), le premier moyen et le second moyen étant prévus pour compenser un écart de potentiel auquel la paire de lignes de bits (B, $\overline{B}$) est préchargé en court-circuitant les lignes de bits, l'écart étant dû aux capacitances du noeud commun et du premier condensateur.

5. Mémoire dynamique selon la revendication 4, dans laquelle une capacitance du second condensateur (Cx) est sélectionnée à la somme des capacitance du noeud commun (Nc) et du premier condensateur.

8

**EP 0 189 908 B1**

**6.** Mémoire dynamique selon la revendication 4, dans laquelle le moyen de mise en court-circuit comporte un troisième transistor ($Q_{20}$) ayant un trajet source-drain couplé entre une ligne de bits parmi les lignes de bits et le noeud commun (Nc) et un quatrième transistor ($Q_{21}$) couplé entre l'autre ligne de bits parmi la paire des lignes de bits et le noeud commun (Nc).

**7.** Mémoire dynamique comprenant une multitude de paires de lignes de bits (B, $\overline{B}$), une multitude de moyens d'amplification ($Q_1$, $Q_2$, $Q_{12}'$) prévus pour la multitude de paires de lignes de bits, chacun des moyens d'amplification étant connecté à chaque paire des lignes de bits (B, $\overline{B}$) pour amplifier de manière fonctionnelle les potentiels sur la paire des lignes de bits en première et seconde tensions et comportant une capacitance interne, un moyen pour activer simultanément la multitude des amplificateurs de lecture, une multitude de premiers moyens prévus pour la multitude des paires des lignes de bits, chacun des premiers moyens ($Q_{20}$, $Q_{21}$ ; $Q_{20}'$, $Q_{21}'$) court-circuitant de manière fonctionnelle chaque paire des lignes de bits (B, $\overline{B}$) après que les potentiels sur chaque paire de lignes de bits soient amplifiés par les moyens d'amplification ($Q_1$, $Q_2$, $Q_{12}'$), la capacitance interne de chacun des moyens d'amplification étant connectée à la paire associée de lignes de bits lorsque la paire associée des lignes de bits est court-circuitée, caractérisée en ce qu'elle comprend un moyen de condensateur (Cx'), un second moyen ($Q_{23}$) pour charger le moyen de condensateur (Cx') avant que la multitude des amplificateurs de lecture soient activés et un troisième moyen pour connecter de manière fonctionnelle le moyen de condensateur (Xc') aux noeuds internes des moyens de amplification lorsque chaque paire des lignes de bits est court-circuitée, le moyen de condensateur (Cx'), le second moyen et le troisième moyen étant prévus pour compenser un écart de potentiel auquel la paire des lignes de bits (B, $\overline{B}$) est préchargé en court-circuitant les lignes de bits, l'écart étant dû aux capacitances internes de la multitude des moyens d'amplification.

**8.** Mémoire dynamique selon la revendication 7, dans laquelle le moyen de capacitance (Cx) présente une capacitance pratiquement égale à une capacitance totale des capacitances internes.

<div align="center">9</div>

FIG. 1
PRIOR ART

FIG. 2 PRIOR ART

FIG. 3

FIG. 5

FIG. 4

FIG. 6